# EUROPÄISCHE PATENTSCHRIFT

(11) **EP 1 412 969 B1**
(45) Veröffentlichungstag und Bekanntmachung des Hinweises auf die Patenterteilung: **21.03.2007**
(21) Anmeldenummer: 02753028.6
(22) Anmeldetag: 18.07.2002
(51) Int. Cl.: H01L 21/027

(54) **VERFAHREN ZUM HERSTELLEN EINER SELBSTJUSTIERTEN STRUKTUR AUF EINEM HALBLEITER-WAFER**
METHOD FOR THE PRODUCTION OF A SELF-ADJUSTED STRUCTURE ON A SEMICONDUCTOR WAFER
PROCEDE DE REALISATION D'UNE STRUCTURE A AJUSTAGE AUTOMATIQUE SUR UNE TRANCHE DE SEMI-CONDUCTEUR

(30) Priorität: 02.08.2001 DE 10137830
(43) Veröffentlichungstag der Anmeldung: 28.04.2004
(73) Patentinhaber: Infineon Technologies AG, 81669 München (DE)
(72) Erfinder: GOLDBACH, Matthias, 01099 Dresden (DE); HECHT, Thomas, 01099 Dresden (DE); LÜTZEN, Jörn, 01099 Dresden (DE); SELL, Bernhard, 97210 Portland (US)
(74) Vertreter: Graf Lambsdorff, Matthias
(86) Internationale Anmeldenummer: PCT/DE2002/002651
(87) Internationale Veröffentlichungsnummer: WO 2003/017342

(56) Entgegenhaltungen:
- EP-A- 0 083 397
- EP-A- 0 523 768
- US-A- 5 879 866
- US-A- 5 981 150
- US-A- 6 022 764
- US-A- 6 080 654

## Beschreibung

Die Erfindung betrifft ein Verfahren zum Herstellen einer selbstjustierten Struktur auf einem Halbleiter-Wafer.

Durch den Fortschritt in der Halbleitertechnologie können integrierte Schaltkreise mit einem sehr hohen Integrationsgrad hergestellt werden. Der Integrationsgrad reicht dabei von VLSI(very large scale integration) über ULSI (ultra large scale integration) bis hin zu noch höheren Packungsdichten. Die Kapazität eines einzigen Halbleiterchips steigt dabei von ehemals einigen Tausend Bauelementen über hunderttausend bis hin zu derzeit mehreren Millionen Bauelementen an. Betrachtet man beispielsweise DRAM(Dynamic Random Access Memories) Bauelemente, so kann durch den enormen Integrationsgrad in der Herstellung die Kapazität eines einzelnen Chips von ehemals 4 Mbit oder 16 Mbit bis hin zu 256 Mbit oder mehr erreicht werden.

Bauelemente in integrierten Schaltkreisen wie beispielsweise Transistoren oder Kondensatoren müssen dabei immer mehr verkleinert werden und an die Anforderungen der integrierten Schaltkreise angepaßt werden. Die ansteigende Packungsdichte von integrierten Schaltkreisen und die damit einhergehende Verkleinerung der Bauelemente stellt eine große Herausforderung an die Halbleiter-Prozeßtechnik dar. So muß bei der Herstellung eines Elements oder eines Bauelements eines integrierten Schaltkreises darauf geachtet werden, daß dabei die elektrischen Kenngrößen und Charakteristiken der anderen Bauelemente auf dem integrierten Schaltkreis nicht verändert oder beeinflußt werden. Dies bedeutet, daß die Herstellung der Bauelemente im Hinblick auf eine hohe Packungsdichte, eine niedrige Wärmeerzeugung und einen niedrigen Energieverbrauch in Verbindung mit einer hohen Zuverlässigkeit und einer langen Lebensdauer bei der Herstellung erreicht werden muß, ohne gleichzeitig einen Qualitätsverlust in der Funktion des Bauelements hinnehmen zu müssen. Es wird dabei angenommen, daß diese Vorgaben durch paralleles Weiterentwickeln und Verbessern in der Photolithographie, den Ätzprozessen, der Abscheidung, der Ionenimplantation und den thermischen Prozessen, also den fünf wesentlichen Aspekten der Halbleitertechnologie, erreicht werden kann.

Bei einem bekannten Verfahren zum Herstellen einer DRAM-Zellenanordnung (DE 198 45 058 A1) werden in einem Substrat im wesentlichen parallel zueinander verlaufende erste Gräben erzeugt. Die ersten Gräben werden mit Trennstrukturen gefüllt. Durch Ätzen mit Hilfe einer streifenförmigen Photolackmaske, deren Streifen quer zu den ersten Gräben verlaufen, wird das Substrat selektiv zu den Trennstrukturen geätzt, so daß Vertiefungen erzeugt werden. Flächen von unteren Bereichen der Vertiefungen werden mit einem Kondensatordielektrikum versehen. In den unteren Bereichen der Vertiefungen wird jeweils ein Speicherknoten eines Speicherkondensators erzeugt. Obere Source/Drain-Gebiete der Transistoren werden so erzeugt, daß sie jeweils zwischen zwei zueinander benachbarten Vertiefungen und zwischen zueinander benachbarten Trennstrukturen angeordnet sind und an eine Hauptfläche des Substrats angrenzen.

Untere Source/Drain-Gebiete der Transistoren im Substrat werden so gebildet, daß sie mit den Speicherknoten elektrisch verbunden sind, so daß jeweils einer der Transistoren und einer der Speicherkondensatoren in Reihe geschaltet sind und eine Speicherzelle bilden. Durch Abscheiden und Strukturieren mit Masken von leitendem Material werden Wortleitungen, die quer zu den Trennstrukturen oberhalb der Hartfläche verlaufen, und daran angrenzende Gate-Elektroden von vertikalen Transistoren erzeugt, die jeweils in einer der Vertiefungen angeordnet und von den Speicherknoten elektrisch isoliert sind. Über den Wortleitungen wird eine isolierende Schicht erzeugt. Durch Abscheiden und Rückätzen von Material werden isolierende Spacer an Flanken der Wortleitungen erzeugt. Mit Hilfe einer streifenförmigen Photolackmaske, deren Streifen im Wesentlichen parallel zu den Trennstrukturen verlaufen, wird selektiv zur isolierenden Schicht und den Spacern geätzt, bis die oberen Source/Drain-Gebiete freigelegt werden.

Dabei ist bei dem bekannten Verfahren ein Nachteil darin zu sehen, daß bei den lithographischen Prozessen unter Verwendung von Masken immer das Problem der relativen Justierung ("Overlay") von Maske und Struktur auf dem Wafer besteht. Somit wird die Justierung von Maske und Struktur auf dem Wafer mit zunehmender Verkleinerung der Bauelemente ein größeres Problem.

Bei einem weiteren bekannten Verfahren (US 5 935 763) wird eine maskenlose Strukturierung eines lichtempfindlichen Materials auf einem Substrat offenbart. Das Substrat weist dabei Bereiche mit unterschiedlichem Reflexionsverhalten auf. Ein paralleles Lichtstrahlenbündel wird dabei senkrecht auf das lichtempfindliche Material eingestrahlt. Das einfallende Licht wird dabei an den reflektierenden Bereichen reflektiert und daher in das lichtempfindliche Material zurückgestrahlt. Dadurch wird das lichtempfindliche Material senkrecht über den reflektierenden Bereichen des Substrats belichtet und durch einen späteren Entwicklungsschritt abgetragen, wodurch eine Öffnung in dem lichtempfindlichen Material entsteht, welche vertikal über dem reflektierenden Bereich des Substrats selbstjustiert ausgebildet wird.

Ein Nachteil des bekannten Verfahrens ist darin zu sehen, daß eine erwünschte Struktur lediglich vertikal über der in dem Substrat dargestellten Struktur in das lichtempfindliche Material abgebildet werden kann. Eine Substratstruktur kann daher lediglich vertikal und maßstabsgetreu mit einem Maßstab 1:1 abgebildet werden.

Aufgabe der Erfindung ist es, ein Verfahren zum Herstellen einer selbstjustierten Struktur auf einem Halbleiter-Wafer zu schaffen, bei dem ein Abbilden der Substratstruktur in das lichtempfindliche Material versetzt zur Substratstruktur durchgeführt werden kann.

Diese Aufgabenstellung wird durch ein Verfahren, das die Schritte nach Patentanspruch 1 aufweist, gelöst.

Bei einem Verfahren zum Herstellen einer selbstjustierten Struktur auf einem Halbleiter-Wafer wird eine Struktur auf einer Schichtenoberfläche des Halbleiter-Wafers mit zumindest einem ersten Flächenbereich, an dem eine elektromagnetische Strahlung reflektiert wird und zumindest einem zweiten Flächenbereich, durch den die elektromagnetische Strahlung nahezu vollständig hindurchtritt, ausgebildet. Zumindest auf den beiden Flächenbereichen der Schichtenoberfläche wird eine lichtdurchlässige Isolationsschicht erzeugt. Wiederum unmittelbar auf diese lichtdurchlässige Isolationsschicht wird eine lichtempfindliche Schicht ausgebildet. Ein paralleles elektromagnetisches Strahlenbündel wird auf eine gesamte Oberfläche der lichtempfindlichen Schicht eingestrahlt.

Erfindungsgemäß wird das parallele elektromagnetische Strahlenbündel mit einem Einfallswinkel Θ schräg auf die Oberfläche der lichtempfindlichen Schicht eingestrahlt. Der Einfallswinkel Θ wird dabei derart vorgegeben, dass die Struktur der Schichtenoberfläche mit einem lateralen Versatz in die lichtempfindliche Schicht abgebildet wird, wobei die Bestrahlungsdosis des elektromagnetischen Strahlenbündels (LB) derart gewählt wird, dass ein Schwellwert der lichtempfindlichen Schicht (14) erst dann überschritten wird, wenn die lichtempfindliche Schicht mit der Bestrahlungsdosis des einfallenden Strahlenbündels und der Bestrahlungsdosis des an dem ersten Flächenbereich (8, 9) reflektierten Strahlenbündels bestrahlt wird.

Dadurch kann erreicht werden, daß eine Struktur auf der Schichtenoberfläche des Halbleiter-Wafers selbstjustiert und versetzt zur Struktur der Schichtenoberfläche in die lichtempfindliche Schicht abgebildet werden kann. Dadurch kann auch erreicht werden, dass eine Abbildung flächengedehnt oder -gestaucht durchgeführt werden kann.

Vorteilhafte Ausgestaltungen sind in den Unteransprüchen angegeben.

Es kann dabei vorgesehen sein, daß der Strahlengang der elektromagnetischen Strahlung durch die lichtempfindliche Schicht und die lichtdurchlässige Isolationsschicht durch einen Brechungsindex n₁ der Isolationsschicht und/oder einen Brechungsindex n₂ der lichtdurchlässigen Schicht und/oder durch eine Schichtdicke der Isolationsschicht und/oder der lichtempfindlichen Schicht eingestellt wird. Dadurch kann erreicht werden, daß das versetzte Ausbilden der Struktur der Schichtenoberfläche in der lichtempfindlichen Schicht durch mehrere Parameter eingestellt wird. Je nach Anforderung an das Abbilden der Struktur der Schichtenoberfläche in die lichtempfindliche Schicht können dadurch ein oder mehrere Parameter ausgewählt und variiert und entsprechend ein schnelles und kostengünstiges Abbilden der Struktur erreicht werden. Des Weiteren kann dadurch erreicht werden, daß durch Ändern der Parameter eine große Vielfalt an Abbildungsmöglichkeiten der Struktur der Schichtenoberfläche in die lichtempfindliche Schicht möglich ist. Somit kann auch erreicht werden, daß eine Struktur der Schichtenoberfläche nicht nur versetzt, sondern auch beispielsweise längen- und/oder breitengedehnt oder geschrumpft in der lichtempfindlichen Schicht abgebildet werden kann.

Es kann auch vorgesehen sein, daß die Schichtenoberfläche eben ausgebildet und die Struktur der Schichtenoberfläche nahezu maßstabsgetreu und lediglich um einen Abstand a horizontal und parallel versetzt zur Schichtenoberfläche in die lichtempfindliche Schicht abgebildet wird.

Dadurch kann erreicht werden, daß eine Struktur der Schichtenoberfläche nahezu maßstabsgetreu mit einem erwünschten Versatz a ausgebildet wird.

Es kann auch vorgesehen sein, daß die lichtempfindliche Schicht zumindest teilweise mit einer Schutzvorrichtung abgedeckt und die einfallende elektromagnetische Strahlung an dieser Schutzvorrichtung reflektiert und/oder absorbiert wird.

Dadurch kann erreicht werden, daß lediglich Teilbereiche der Schichtenoberfläche in die lichtempfindliche Schicht abgebildet werden.

Die Erfindung wird nachfolgend unter Bezugnahme auf die Zeichnungen anhand von Ausführungsbeispielen näher erläutert.
Es zeigen:
- Figuren 1-4: die einzelnen Schritte einer ersten Ausführungsvariante der Herstellung einer selbstjustierten Struktur,
- Figur 5: eine Draufsicht auf die gemäß Figur 4 erzeugten selbstjustierten Struktur und
- Figur 6: ein weiteres Ausführungsbeispiel einer Struktur einer Schichtenoberfläche.

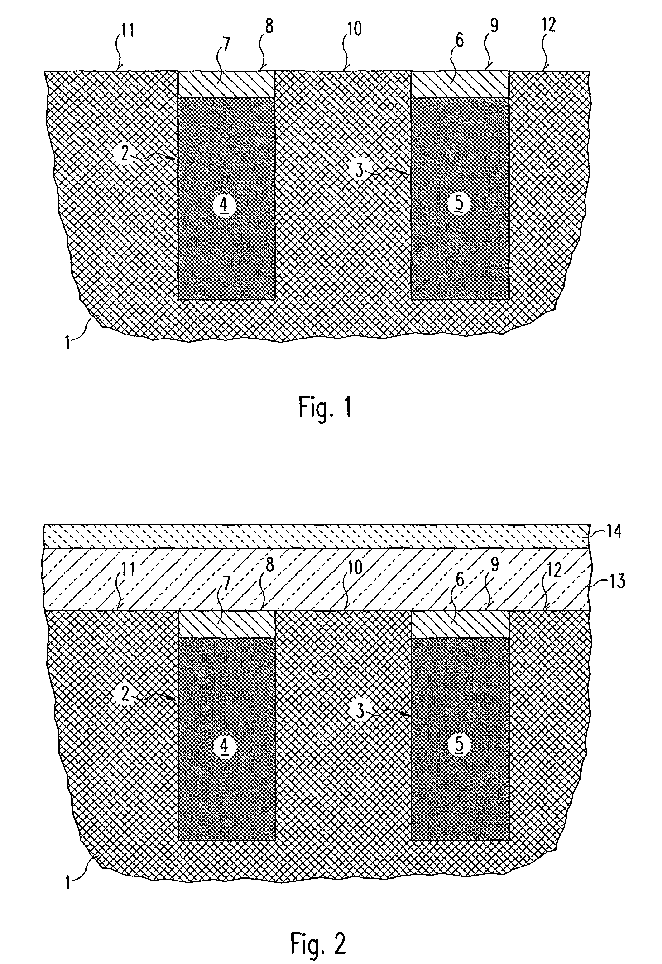

In einem Siliziumsubstrat 1 (Figur 1) wird ein erster Graben 2 und ein zweiter Graben 3 erzeugt. Die Gräben 2 und 3 können dabei beispielsweise durch einen Plasmaätzprozeß mit HBr/NF₃ ausgebildet werden. Die Gräben 2 und 3 weisen beispielsweise eine Tiefe von 5 µm, eine Weite von 100x250nm und einen gegenseitigen Abstand von 100nm auf.

Wie bereits aus dem Stand der Technik bekannt ist, können auf die Wände der Gräben 2 und 3 weitere nicht dargestellte Schichten abgeschieden und die Gräben 2 und 3 mit Polysiliziumschichten 4 bzw. 5, die in die Gräben abgeschieden werden, gefüllt werden. Auf diese Polysiliziumschichten 4 und 5 werden reflektierende Schichten abgeschieden. Als reflektierende Schichten wird dabei eine Metallschicht 6 auf die Polysiliziumschicht 5 und eine Metallschicht 7 auf die Polysiliziumschicht 4 abgeschieden. Durch chemisch-mechanisches Polieren (CMP) bis zur Siliziumsubstratoberfläche oder beispielsweise bis zu einer nicht dargestellten SiN-Schicht wird eine ebene Schichtenoberfläche erzeugt. Die Schichtenoberfläche besteht dabei aus den reflektierenden Oberflächen 8 und 9 der Metallschichten 7 bzw. 6 sowie den im Wesentlichen nicht reflektierenden Oberflächen 10, 11 und 12 des Siliziumsubstrats 1.

Der CMP-Prozeß wird dabei so ausgeführt, daß abgeschiedenes Metall nur auf den Oberflächen 10,11 und 12 entfernt wird. Die auf die Polysiliziumschichten 4 und 5 abgeschiedenen Metallschichten 7 bzw. 6 werden durch den CMP-Prozeß nicht entfernt.

Nachfolgend wird auf die Schichtenoberfläche, die aus den Flächenbereichen 8,9,10,11 und 12 besteht, eine lichtdurchlässige Schicht 13 abgeschieden. Diese lichtdurchlässige Schicht 13 kann dabei beispielsweise eine Siliziumoxidschicht oder auch eine Polymerschicht aus einem photounempfindlichen Polymermaterial sein. Auf diese lichtdurchlässige Schicht 13 wird nachfolgend eine lichtempfindliche Schicht abgeschieden. Die lichtempfindliche Schicht kann beispielsweise eine Lackschicht 14 oder auch ein Mehrschichtlacksystem aus einem oder mehreren lichtempfindlichen Lacken sein.

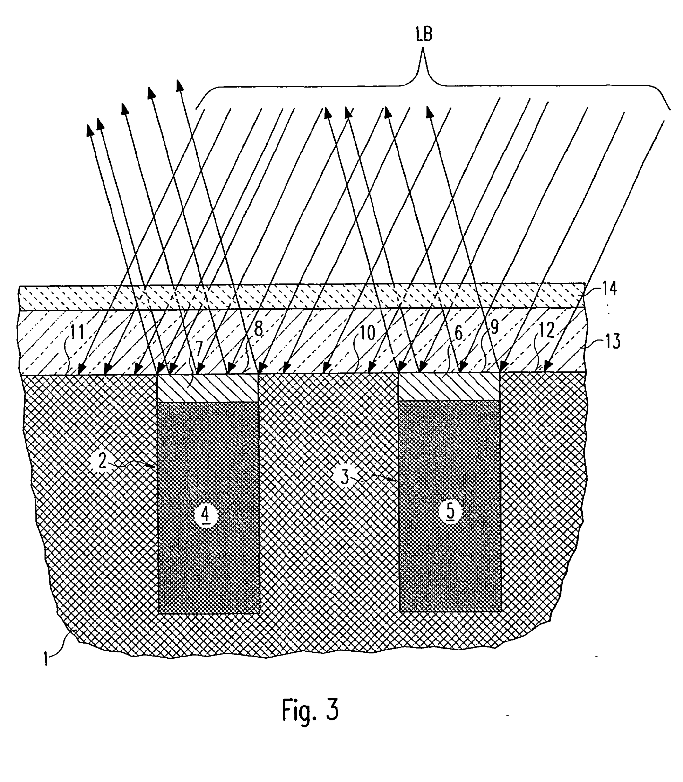

Auf diese lichtempfindliche Lackchicht 14 wird eine elektromagnetische Strahlung, die im Ausführungsbeispiel als ein paralleles Lichtstrahlenbündel LB (Figur3) ausgeführt ist, unter einem Einfallswinkel Θ eingestrahlt. Das Lichtstrahlenbündel LB wird dabei an den Grenzflächen gebrochen und tritt durch die lichtempfindliche Lackschicht 14 und die lichtdurchlässige Schicht 13 hindurch. Derjenige Teil des Lichtstrahlenbündels LB, der auf die Flächenbereiche 10,11 und 12 trifft, wird nicht reflektiert. Derjenige Anteil des Lichtstrahlenbündels LB hingegen, der auf die reflektierenden Flächenbereiche 8 und 9 trifft, wird dort reflektiert und tritt durch die lichtdurchlässige Isolationsschicht 13 und die lichtempfindliche Lackschicht 14 wieder hindurch. Sowohl die Lackschicht 14 als auch die Isolationsschicht 13 weisen dabei einen möglichst niedrigen Absorbtionskoeffizienten für die einfallende elektromagnetische Strahlung auf. Des Weiteren ist die Lackschicht 14 so ausgebildet, daß die Lackschicht 14 einen Schwellwert einer Bestrahlungsdosis aufweist, der erst dann überschritten wird, wenn die Lackschicht 14 mit einer ersten Bestrahlungsdosis des einfallenden Lichtstrahlenbündels LB und zumindest mit einer zweiten Bestrahlungsdosis des reflektierten Anteils des einfallenden Lichtstrahlenbündels LB bestrahlt wird. Dadurch werden lediglich diejenigen Bereiche der Lackschicht 14 belichtet, die mit einer Bestrahlungsdosis bestrahlt werden, die über dem Schwellwert der Bestrahlungsdosis liegt.

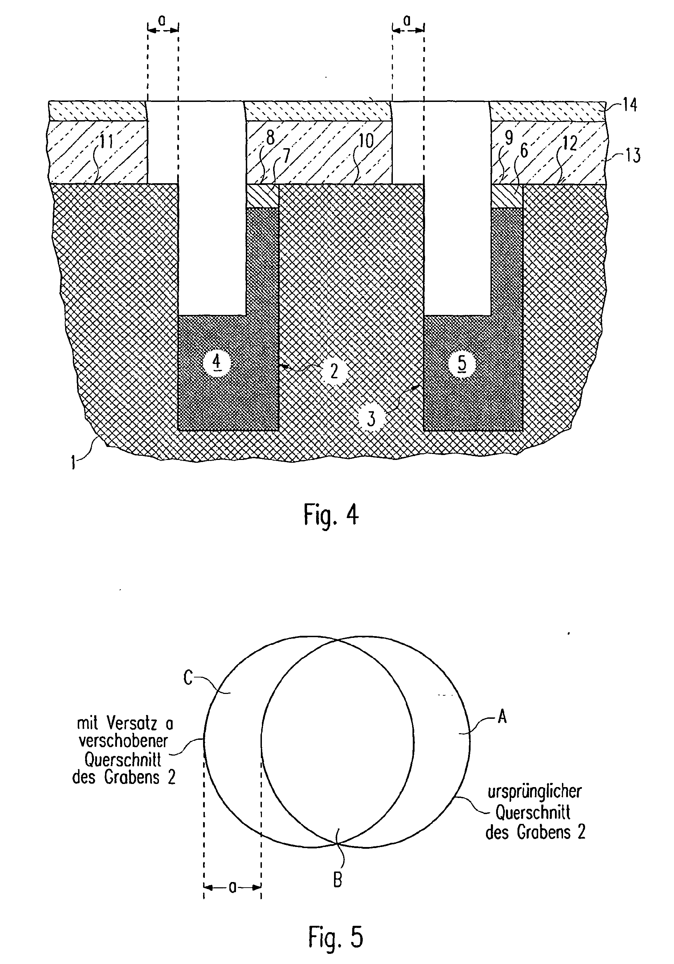

Durch einen nachfolgenden Entwicklungsschritt können diejenigen Bereiche der Lackschicht 14, die belichtet sind, entwikkelt und somit entfernt werden (Figur 4). Anschließend werden beispielsweise durch einen Ätzprozeß diejenigen Bereiche der lichtdurchlässigen Schicht 13, die vertikal unter den entfernten Bereichen der Lackschicht 14 angeordnet sind, entfernt. Die lichtdurchlässige Isolationsschicht 13 kann nachfolgend als Hartmaske für eine anisotrope Ätzung der Metallschichten 6 und 7 sowie der Polysiliziumschichten 5 und 4 der Gräben 3 bzw. 2 verwendet werden. Durch den Einfallswinkel Θ des Lichtstrahlenbündels LB wird ein Versatz der Struktur der Schichtenoberfläche mit den Flächenbereichen 8,9,10,11 und 12 erreicht, der einer Strecke a entspricht. Indem die Flächenbereiche 8,9,10,11 und 12 eben horizontal nebeneinander angeordnet sind, wird die Struktur der Schichtenoberfläche nahezu maßstabsgetreu durch das Lichtstrahlenbündel LB in die Lackschicht 14 abgebildet.

In Figur 5 ist eine Draufsicht auf den in Figur 4 dargestellten Schnitt durch den Halbleiter-Wafer dargestellt. Die Gräben 2 und 3 werden in den Figuren 1-4 als Zylinder ausgebildet, so daß in der Draufsicht in Figur 5 Kreisflächen dargestellt sind. Die kreisrunde Oberfläche des Grabens 2 (Figuren 1-4) ist dabei um die Strecke a versetzt. Der mit A bezeichnete halbmondförmige Flächenbereich zeigt dabei den Bereich der Lackschicht 14 (Figuren 1-4), der vertikal über dem Graben 2 angeordnet ist und aufgrund des Versatzes a nicht entwickelt und somit nicht entfernt worden ist. Das Flächenelement B zeigt dabei den Teilbereich des gesamten Flächenquerschnitts des Grabens 2, der aufgrund des Versatzes a geätzt wird. Entsprechend der Darstellung in Figur 4 ist somit in dem Flächenelement B eine Draufsicht auf die Polysiliziumschicht 4 (Figuren 1-4) dargestellt. Des Weiteren ist in dem halbmondförmigen Flächenelement C die Sicht auf die Oberfläche 11 (Figur 1-4) des Siliziumsubstrats 1 dargestellt.

Im Ausführungsbeispiel sind die Gräben 2 und 3 als zylinderförmige Säulen ausgeführt. Selbstverständlich können die Gräben 2 und 3 auch derart ausgeführt werden, daß bei einer Draufsicht gemäß Figur 5 eine ovale, eine eckige oder eine beliebige andere geometrische Flächendarstellung der Oberfläche der Gräben 2 und 3 auftritt.

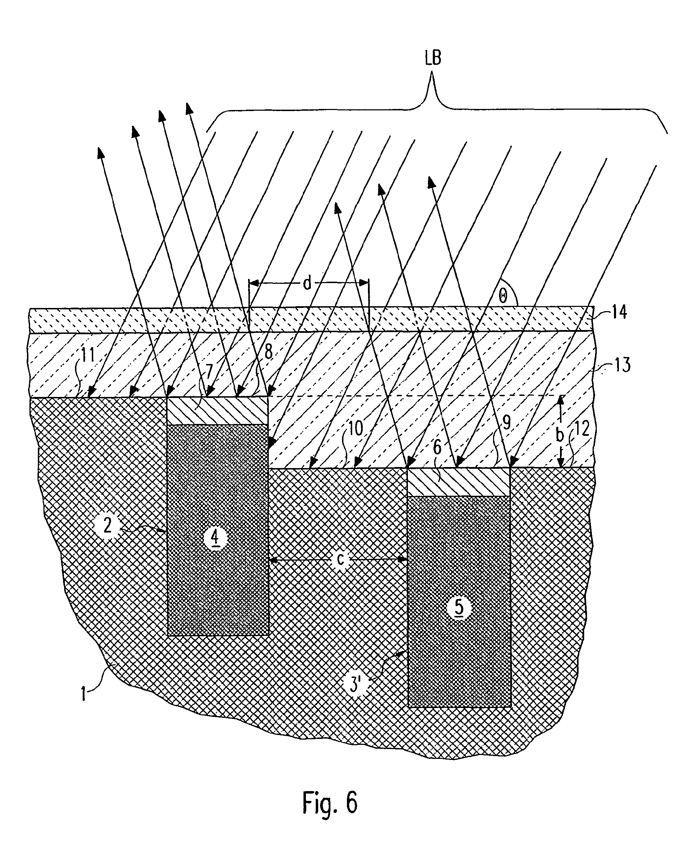

In einem zweiten Ausführungsbeispiel ist der Graben 3' (Figur 6) gegenüber dem Graben 2 um eine Strecke b vertikal versetzt. Indem das Lichtstrahlenbündel LB unter dem Einfallswinkel Θ auf die lichtempfindliche Lackschicht 14 eingestrahlt wird, wird die aus den Flächenbereichen 8,9,10,11 und 12 bestehende Schichtenoberfläche gemäß dem aus der Beschreibung zu den Figuren 1-5 durchgeführten Verfahren in der Lackschicht 14 abgebildet. Aufgrund des vertikalen Versatzes b des Grabens 3' gegenüber dem Graben 2, wird der horizontale Abstand c zwischen den Gräben 2 und 3' in der Lackschicht 14 vermindert dargestellt und weist den Abstand d auf. Somit wird die Struktur der Schichtenoberfläche in der Lackschicht 14 verkleinert dargestellt.

Des Weiteren kann auch vorgesehen sein, daß die Oberfläche 8 der Metallschicht 7 und/oder die Oberfläche 9 der Metallschicht 6 uneben, beispielsweise stufenförmig, ausgeführt wird. Die Metallschicht kann dabei beispielsweise aus Aluminium, Chrom, Nickel oder Gold sein. Es kann auch eine metallhaltige Schicht aus Wolframsilizid als Metallschicht 7 ausgeführt werden.

Des Weiteren kann auch vorgesehen sein, aufgrund fertigungstechnischer Anforderungen den Einfallswinkel Θ, mit dem das Lichtstrahlenbündel LB auf die lichtempfindliche Lackschicht 14 eingestrahlt wird, fest vorzugeben. Ein erwünschter Versatz der Struktur der Schichtenoberfläche der Flächenbereiche 8,9,10,11 und 12 wird dann durch geeignete Wahl eines Brechungsindex n₁ der Isolationsschicht 13 und/oder eines Brechnungsindex n₂ der lichtempfindlichen Lackschicht 14 und/oder der Schichtdicke der Isolationschicht 13 und/oder der lichtempfindlichen Lackschicht 14 erreicht werden.

Es kann auch vorgesehen sein, zumindest einen Teilbereich der lichtempfindlichen Lackschicht 14 mit einer Schutzvorrichtung derart zu bedecken, daß Teile des Lichtstrahlenbündels LB von dieser Schutzvorrichtung absorbiert oder an dieser Schutzvorrichtung reflektiert werden und der restliche Teil des Lichtstrahlenbündels LB beispielsweise nur noch auf die Flächenbereiche 8,10 und 11 (Figuren 1-4; Figur 5) auftrifft. Dadurch kann erreicht werden, daß lediglich Teilstrukturen der Struktur der Schichtenoberfläche in die lichtempfindliche Lackschicht 14 abgebildet werden.

Selbstverständlich kann durch Verwendung eines negativen Lacks für die lichtempfindliche Lackschicht 14 ein Negativ der Struktur der Schichtenoberfläche der Flächenbereiche 8,9,10,11 und 12 (Figuren 1-4; Figur 5) erzeugt werden.

Bei dem Verfahren zum Herstellen einer selbstjustierten Struktur auf einem Halbleiter-Wafer kann durch das Einstrahlen eines parallelen elektromagnetischen Strahlungsbündels mit einem Einfallswinkel Θ auf eine lichtempfindliche Schicht eine Struktur auf einer Schichtenoberfläche des Halbleiter-Wafers mit einem lateralen Versatz in die lichtempfindliche Schicht abgebildet werden. Es kann dadurch beispielsweise eine Integration gefalteter Elektroden oder die Integration eines einseitigen elektrischen Anschlusses eines Transistors an einen Kondensator, beispielsweise einen Grabenkondensator, in einem Speicherbauelement, erreicht werden.

## Patentansprüche

1. Verfahren zum Herstellen einer selbstjustierten Struktur auf einem Halbleiter-Wafer, das folgende Schritte aufweist:
(a) Ausbilden einer Struktur auf einer Schichtenoberfläche des Halbleiter-Wafers mit zumindest einem ersten Flächenbereich (8,9), an dem eine elektromagnetische Strahlung reflektiert wird und zumindest einem zweiten, im Wesentlichen nicht reflektierenden Flächenbereich (10,11,12),
(b) Erzeugen einer lichtdurchlässigen Isolationsschicht (13) zumindest auf den beiden Flächenbereichen (8,9,10,11,12,) der Schichtenoberfläche,
(c) Erzeugen einer lichtempfindlichen Schicht (14) auf der lichtdurchlässigen Isolationsschicht (13),
(d) Einstrahlen eines parallelen elektromagnetischen Strahlenbündels (LB) auf eine Oberfläche der lichtempfindlichen Schicht (14),
(e) Entwickeln der lichtempfindlichen Schicht (14),
wobei
- das parallele elektromagnetische Strahlenbündel (LB) schräg mit einem Einfallswinkel Θ auf die lichtempfindliche Schicht (14) gerichtet wird und der Einfallswinkel Θ derart vorgegeben wird, daß die Struktur der Schichtenoberfläche mit einem lateralen Versatz in die lichtempfindliche Schicht (14) abgebildet wird, wobei
- die Bestrahlungsdosis des elektromagnetischen Strahlenbündels (LB) derart gewählt wird, dass ein Schwellwert der lichtempfindlichen Schicht (14) erst dann überschritten wird, wenn die lichtempfindliche Schicht mit der Bestrahlungsdosis des einfallenden Strahlenbündels und der Bestrahlungsdosis des an dem ersten Flächenbereich (8, 9) reflektierten Strahlenbündels bestrahlt wird..

2. Verfahren nach Anspruch 1,
**dadurch gekennzeichnet,**
- **daß** der Einfallswinkel Θ abhängig von fest vorgegebenen Schichtdicken der Isolationsschicht (13) und/oder der lichtempfindlichen Schicht und fest vorgegebener Brechungsindizes n₁ und/oder n₂ der Isolationsschicht (13) bzw. der lichtempfindlichen Schicht eingestellt wird.

3. Verfahren nach Anspruch 1,
**dadurch gekennzeichnet,**
- **daß** für einen fest vorgegebenen Einfallswinkel Θ die Schichtdicken der Isolationsschicht (13) und/oder der lichtempfindlichen Schicht und/oder der Brechungsindex n₁ der Isolationsschicht (13) und/oder der Brechungsindex n₂ der lichtempfindlichen Schicht eingestellt wird.

4. Verfahren nach einem der vorigen Ansprüche,
**dadurch gekennzeichnet,**
- **daß** als lichtempfindliche Schicht eine Lackschicht (14) mit einem niedrigen Absorbtionskoeffizienten für die, durch die Lackschicht (14) hindurchtretende elektromagnetische Strahlung ausgebildet wird.

5. Verfahren nach einem der vorigen Ansprüche,
**dadurch gekennzeichnet,**
- **daß** zumindest eine Teilfläche der lichtempfindlichen Schicht mit einer Schutzvorrichtung abgedeckt wird und die einfallende elektromagnetische Strahlung (LB) an dieser Schutzvorrichtung reflektiert und/oder absorbiert wird.

6. Verfahren nach einem der vorigen Ansprüche,
**dadurch gekennzeichnet,**
- **daß** die lichtempfindliche Schicht als Siliziumoxidschicht oder als Schicht aus einem lichtunempfindlichen Polymer erzeugt wird.

7. Verfahren nach einem der vorigen Ansprüche,
**dadurch gekennzeichnet,**
- **daß** der erste Flächenbereich (8,9) als Oberfläche einer Metallschicht oder einer metallhaltigen Schicht ausgebildet wird.

8. Verfahren nach Anspruch 7,
**dadurch gekennzeichnet,**
- **daß** als Metall Aluminium, Kupfer, Chrom, Nickel oder Gold und für eine metallhaltige Schicht Wolframsilizid verwendet wird.

## Claims

1. Method for fabricating a self-aligned structure on a semiconductor wafer, which has the following steps:
(a) formation of a structure on a layer surface of the semiconductor wafer with at least one first area region (8, 9), at which an electromagnetic radiation is reflected, and at least one second, essentially nonreflecting area region (10, 11, 12),
(b) production of a light-transmissive insulation layer (13) at least on the two area regions (8, 9, 10, 11, 12) of the layer surface,
(c) production of a light-sensitive layer (14) on the light-transmissive insulation layer (13),
(d) radiation of a parallel electromagnetic beam (LB) of rays onto a surface of the light-sensitive layer (14),
(e) development of the light-sensitive layer (14),
- the parallel electromagnetic beam (LB) of rays being directed obliquely onto the light-sensitive layer (14) with an angle Θ of incidence and the angle Θ of incidence being prescribed such that the structure of the layer surface is imaged with a lateral offset into the light-sensitive layer (14),
- the irradiation dose of the electromagnetic beam (LB) of rays being chosen in such a way that a threshold value of the light-sensitive layer (14) is exceeded only when the light-sensitive layer is irradiated with the irradiation dose of the incident beam of rays and the irradiation dose of the beam of rays reflected at the first area region (8, 9).

2. Method according to Claim 1,
**characterized in that**
- the angle Θ of incidence is set in a manner dependent on fixedly predetermined layer thicknesses of the insulation layer (13) and/or of the light-sensitive layer and fixedly predetermined refractive indices n₁ and/or n₂ of the insulation layer (13) and of the light-sensitive layer, respectively.

3. Method according to Claim 1,
**characterized in that**
- the layer thicknesses of the insulation layer (13) and/or of the light-sensitive layer and/or the refractive index n₁ of the insulation layer (13) and/or the refractive index n₂ of the light-sensitive layer is set for a fixedly predetermined angle Θ of incidence.

4. Method according to one of the preceding claims,
**characterized in that**
- a resist layer (14), having a low absorption coefficient for the electromagnetic radiation which passes through the resist layer (14), is formed as the light-sensitive layer.

5. Method according to one of the preceding claims,
**characterized in that**
- at least one partial area of the light-sensitive layer is covered with a protection device and the incident electromagnetic radiation (LB) is reflected and/or absorbed at said protection device.

6. Method according to one of the preceding claims,
**characterized in that**
- the light-sensitive layer is produced as a silicon oxide layer or as a layer made of a light-insensitive polymer.

7. Method according to one of the preceding claims,
**characterized in that**
- the first area region (8, 9) is formed as a surface of a metal layer or of a metal-containing layer.

8. Method according to Claim 7,
**characterized in that**
- aluminium, copper, chromium, nickel or gold is used as the metal and tungsten silicide is used for a metal-containing layer.

## Revendications

1. Procédé de production d'une structure à autoalignement sur une tranche de semiconducteur, qui a des stades suivants :
a) on forme une structure sur une surface de couche de la tranche de semiconducteur ayant au moins une première partie (8, 9) superficielle sur laquelle est réfléchi un rayonnement électromagnétique et au moins une deuxième partie (10, 11, 12) superficielle sensiblement non réfléchissante,
b) on produit une couche (13) isolante transparente au moins sur les deux parties (8, 9, 10, 11, 12) superficielles de la surface de couche,
c) on produit une couche (14) sensible à la lumière sur la couche (13) isolante transparente,
d) on envoie un faisceau (LB) de rayonnement électromagnétique parallèle sur une surface de la couche (14) sensible à la lumière,
e) on développe la couche (14) sensible à la lumière dans lequel
- on dirige le faisceau (LB) de rayonnement électromagnétique parallèle de manière inclinée, en ayant un angle θ d'incidence, sur la couche (14) sensible à la lumière et on prescrit l'angle θ d'incidence de manière à reproduire la structure de la surface de couche avec un décalage latéral dans la couche (14) sensible à la lumière, dans lequel
- on choisit la dose de rayonnement du faisceau (LB) de rayonnement électromagnétique de façon à ne dépasser une valeur de seuil de la couche (14) sensible à la lumière que lorsque la couche sensible à la lumière est exposée à la dose de rayonnement du faisceau de rayonnement incident et à la dose de rayonnement du faisceau de rayonnement réfléchi sur la première partie (8, 9) superficielle.

2. Procédé suivant la revendication 1,
**caractérisé**
- **en ce que** l'on règle l'angle θ d'incidence en fonction d'épaisseurs prescrites de manière fixe de la couche (13) isolante et/ou de la couche sensible à la lumière et d'indices n₁ et/ou n₂ de réfraction prescrits de manière fixe de la couche (13) isolante ou de la couche sensible à la lumière.

3. Procédé suivant la revendication 1,
**caractérisé**
- **en ce que**, pour un angle θ d'incidence prescrit de manière fixe, on règle les épaisseurs de la couche (13) isolante et/ou de la couche sensible à la lumière et/ou l'indice n₁ de réflexion de la couche (13) isolante et/ou l'indice n₂ de réflexion de la couche sensible à la lumière.

4. Procédé suivant l'une des revendications précédentes,
**caractérisé**
- **en ce que** l'on constitue comme couche sensible à la lumière, une couche (14) de vernis, ayant un petit coefficient d'absorption du rayonnement électromagnétique passant à travers la couche (14) de vernis.

5. Procédé suivant l'une des revendications précédentes,
**caractérisé**
- **en ce que** l'on recouvre au moins une surface partielle de la couche sensible à la lumière d'un dispositif de protection et on réfléchit et/ou absorbe le rayonnement (LB) électromagnétique sur ce dispositif de protection.

6. Procédé suivant l'une des revendications précédentes,
**caractérisé**
- **en ce que** l'on produit la couche sensible à la lumière sous la forme d'une couche d'oxyde de silicium ou sous la forme d'une couche en un polymère sensible à la lumière.

7. Procédé suivant l'une des revendications précédentes,
**caractérisé**
- **en ce que** l'on constitue la première partie (8, 9) superficielle sous la forme d'une surface d'une couche métallique ou d'une couche contenant du métal.

8. Procédé suivant la revendication 7,
**caractérisé**
- **en ce que** l'on utilise, comme métal, de l'aluminium, du cuivre, du chrome, du nickel ou de l'argent et, comme couche contenant du métal, du siliciure de tungstène.
